# EUROPEAN PATENT APPLICATION

(11) **EP 2 341 549 A2**
(43) Date of publication of application: **06.07.2011**
(21) Application number: 10016131.4
(22) Date of filing: 28.12.2010
(51) Int. Cl.: H01L 31/0224, H01L 31/068, H01L 31/18

(54) **Solar cell structure and manufacturing method thereof**

(30) Priority: 29.12.2009 TW 98145633
(71) Applicant: Auria Solar Co., Ltd., Tainan 74146 (TW)
(72) Inventor: Tsai, Chin-Yao, Sinshih Township Tainan 74146 (TW)
(74) Representative: Brandenburger, Karin

(57) **Abstract**

A solar cell structure including a photovoltaic layer, an upper electrode, a lower electrode, and a passivation layer is provided. The photovoltaic layer has an upper surface, a lower surface and a plurality of side surfaces, wherein the photovoltaic layer includes a first type and a second type semiconductor layer. The upper electrode is disposed at the upper surface of the photovoltaic layer and electrically connected with the second type semiconductor layer, wherein the second type semiconductor layer is between the upper electrode and the first type semiconductor layer. The bottom electrode is disposed at the bottom surface of the photovoltaic layer and electrically connected with the first type semiconductor layer, wherein the first type semiconductor layer is between the bottom electrode and the second type semiconductor. The passivation layer covers at least one of the side surfaces so as to reduce the leakage current formed on the side surfaces.

## Description

This application claims priority to Taiwan Patent Application No. 098145633 filed on December 29,2009, which is hereby incorporated by reference in its entirely.

### CROSS-REFERENCES TO RELATED APPLICATIONS

Not applicable.

### BACKGROUND OF THE INVENTION

### Field of the Invention

The present invention relates to a solar cell structure and a manufacturing method thereof, and more particularly, to a solar cell structure with preferred photoelectric conversion efficiency and a manufacturing method thereof.

### Descriptions of the Related Art

With rising of the environmental protection awareness, the concept of "energy saving and carbon dioxide emission reduction" is gradually receiving more and more attention. Accordingly, exploitation and use of renewable energy sources have become a focus of development all over the world Among the renewable energy sources, solar cells that are capable of converting the solar energy into the electric energy are considered to be the most promising, so numerous manufacturers are now devoted to production of solar cells. Currently, a critical problem related to solar cells is how to improve the photoelectric conversion efficiency thereof, and any improvement in the photoelectric conversion efficiency of solar cells will lead to improvement in competitive edge of the solar cell products.

A typical solar cell structure may comprise a substrate, a P-N diode and two metal electrodes. Generally, a solar cell operates in the following principle: when the P-N diode of the solar cell is irradiated by the sunlight, the energy provided by the photons can excite electrons in the semiconductor to become free to generate electron-hole pairs. As influenced by a built-in electric potential, the holes migrate towards the electric field while the electrons migrate in an opposite direction. Then, if a conductor is used to electrically connect a load to the electrodes of the solar cell, a current will flow through the load. The solar cell just operates in this principle to generate electric power, which is also known as the photovoltaic effect,

In order to improve the photoelectric conversion efficiency of the solar cell, many solutions for improving the solar cell structure have been proposed one after another. Among these solutions, reducing energy loss in energy transmission of the solar cell is known as an important way to achieve this end. For example, electron-hole pairs generated by the solar cell when irradiated by the sunlight tend to cause a leakage current near the P-N junction to cause loss of energy, which will undoubtedly degrade the photoelectric conversion efficiency.

### SUMMARY OF THE INVENTION

In view of this, the present invention provides a solar cell structure, which can reduce occurrence of the leakage current to provide preferred photoelectric conversion efficiency.

The present invention also provides a method for manufacturing the aforesaid solar cell structure.

The solar cell structure of the present invention comprises a photovoltaic layer, an upper electrode, a lower electrode and a passivation layer. The photovoltaic layer has an upper surface, a lower surface and a plurality of side surfaces, wherein the photovoltaic layer comprises a first type semiconductor layer and a second type semiconductor layer. The second type semiconductor layer is physically connected with the first type semiconductor layer. The upper electrode is disposed on the upper surface of the photovoltaic layer and electrically connected with the second type semiconductor layer, wherein the second type semiconductor layer is located between the upper electrode and the first type semiconductor layer. The lower electrode is disposed on the lower surface of the photovoltaic layer and electrically connected with the first type semiconductor layer, wherein the first type semiconductor layer is located between the lower electrode and the second type semiconductor layer. The passivation layer covers at least one of the side surfaces so as to reduce a leakage current formed on the side surfaces,

In an embodiment of the present invention, the photovoltaic layer is made of one of a monocrystalline material and a polycrystalline material.

In an embodiment of the present invention, the photovoltaic layer is made of a monocrystalline or polycrystalline material of at least one of silicon (Si), gallium arsenide (GaAs) and indium phosphide (InP).

In an embodiment of the present invention, wherein the passivation layer is made of a paint, an insulation material, a compound comprising one of the oxygen and nitrogen element or a combination thereof

In an embodiment of the present invention, the compound is made of silicon oxide, silicon nitride, silicon oxynitride, or a combination thereof.

In an embodiment of the present invention, the first type semiconductor layer is a P-type semiconductor layer, and the second type semiconductor layer is an N-type semiconductor layer.

In an embodiment of the present invention the solar cell structure further comprises an anti-reflection layer disposed between the second type semiconductor layer and the upper electrode.

In an embodiment of the present invention, at least one of the upper surface and the lower surface is a texture surface.

The method for manufacturing a solar cell structure of the present invention comprises the following steps of: providing a fist type semiconductor layer; forming a second type semiconductor layer on the first type semiconductor layer so as to form a photovoltaic layer, wherein the photovoltaic layer has an upper surface, a lower surface and a plurality of side surfaces; forming an upper electrode on the upper surface of the photovoltaic layer so as to electrically connect the upper electrode with the second type semiconductor layer, wherein the second type semiconductor layer is located between the upper electrode and the first type semiconductor layer; forming a lower electrode on the lower surface of the photovoltaic layer so as to electrically connect the lower electrode with the first type semiconductor layer, wherein the first type semiconductor layer is located between the lower electrode and the second type semiconductor layer; and forming a passivation layer, whichin the passivation layer covers at least one of the side surfaces so as to reduce a leakage current formed on the side surfaces.

In an embodiment of the present invention, the first type semiconductor layer is a P-type semiconductor layer, and the second type semiconductor layer is an N-type semiconductor layer.

In an embodiment of the present invention, forming the second type semiconductor layer on the first type semiconductor layer comprises performing a doping process on the first type semiconductor layer.

In an embodiment of the present invention, the method for manufacturing a solar cell structure further comprises forming a texture surface on at least one of the upper surface and the lower surface of the photovoltaic layer.

In an embodiment of the present invention forming the texture surface on at least one of the upper surface and the lower surface of the photovoltaic layer comprises performing an etching process.

In an embodiment of the present invention, the method for manufacturing a solar cell structure further comprises forming an anti-reflection layer between the second type semiconductor layer and the upper electrode.

In an embodiment of the present invention, forming the passivation layer comprises performing a plasma process, a coating process, or a thermal process.

In an embodiment of the present invention, forming the upper electrode or forming the lower electrode comprises performing a screen printing process and a thermal process,

According to the above descriptions, the solar cell structure of the present invention has a passivation layer disposed on at least one of the side surfaces of the photovoltaic layer. This can reduce the leakage current formed on the side surfaces of the photovoltaic layer so as to improve photoelectric conversion efficiency of the solar cell structure. Furthermore, a method for manufacturing the aforesaid solar cell structure is also disclosed in the present invention

The detailed technology and preferred embodiments implemented for the subject invention are described in the following paragraphs accompanying the appended drawings for people skilled in this field to well appreciate the features of the claimed invention,

### BRIEF DESCRIPTION OF THE DRAWINGS

**FIG. 1** is a schematic partial view of a solar cell structure according to an embodiment of the present invention;
**FIG. 2** is a schematic partial view of a solar cell structure according to another embodiment of the present invention;
**FIGs. 3A-3E** are a schematic view of illustrate a process of manufacturing a solar cell structure according to an embodiment of the present invention.

### DESCRIPTION OF THE PREFERRED EMBODIMENT

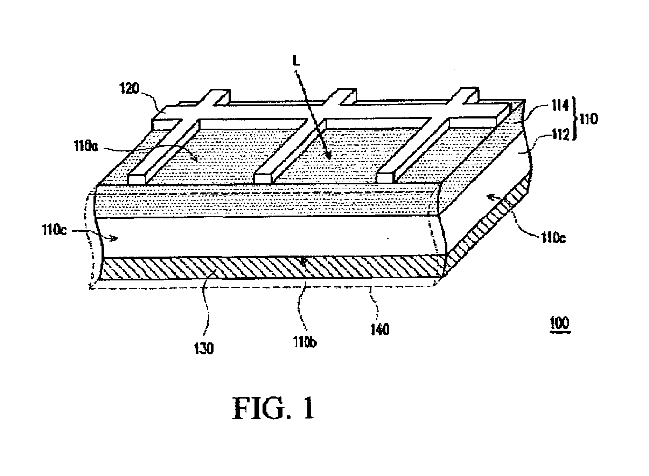

**FIG. 1** is a schematic partial view of a solar cell structure according to an embodiment of the present invention. Referring to **FIG. 1**, the solar cell structure **100** comprises a photovoltaic layer **110,** an upper electrode **120**, a lower electrode **130** and a passivation layer **140.** In this embodiment, the photovoltaic layer **110** may be made of a monocrystalline material or polycrystalline material. For example, the photovoltaic layer **110** may be made of a monocrystalline material or a polycrystalline material of at least one of silicon (Si), gallium arsenide (GaAs) and indium phosphide (InP),

The photovoltaic layer **110** has an upper surface **110a**, a lower surface **110b** and a plurality of side surfaces **110c,** For example, at least one of the upper surface **110a** and the lower surface **110b** may be a texture surface, which can reduce the chance that the light ray **L** is reflected so that the light ray **L** can be well absorbed by the photovoltaic layer **110.** This helps to improve the utilization of the light ray **L** so as to improve the photoelectric conversion efficiency of the solar cell structure **100.**

Additionally, the photovoltaic layer **110** comprises a first type semiconductor layer **112** and a second type semiconductor layer **114** physically connected with each other, as shown in **FIG. 1****.** In this embodiment, the first type semiconductor layer **112** is a P-type semiconductor layer, and the second type semiconductor layer **114** is an N-type semiconductor layer; i.e., the photovoltaic layer **110** is a p-n junction semiconductor layer. However, in other embodiments without depiction herein, the photovoltaic layer **110** may also be of a p-i-n junction design; and in this embodiment, the p-n junction is only provided for illustration but not to limit the present invention.

The upper electrode **120** is disposed on the upper surface **110a** of the photovoltaic layer **110** and electrically connected with the second type semiconductor layer **114,** wherein the second type semiconductor layer **114** is located between the upper electrode **120** and the first type semiconductor layer **112,** as shown in **FIG. 1****.** Additionally, the lower electrode **130** is disposed on the lower surface **110b** of the photovoltaic layer **110** and electrically connected with the first type semiconductor layer **112,** wherein the first type semiconductor layer **112** is located between the lower electrode **130** and the second type semiconductor layer **114.**

In this embodiment, the upper electrode **120** and the lower electrode **130** may generally be made of a metal material, e.g., gold (Au), silver (Ag), copper (Cu), tin (Sn), lead (Pb), hafnium (Hf), tungsten (W), molybdenum (Mo), neodymium (Nd), titanium (Ti), tantalum (Ta), aluminum (Al), zinc (Zn), other metal materials with superior conductivity, or a combination thereof. Furthermore, in this embodiment, the upper electrode **120** and the lower electrode **130** may also be made of a transparent conducting material, e.g., indium tin oxide (ITO), zinc oxide (ZnO), stannic oxide (SnO), indium oxide (InO), or the like. For the upper electrode **120,** besides that it shall be able to collect carriers effectively, a proportion of metal conductors that shield the incident light ray L shall be minimized in the upper electrode **120.** Therefore, the upper electrode **120** may be designed to have a structure of a special pattern. In this embodiment, for example, the upper electrode **120** is comprised of a row of finger-shaped fine metal electrodes extending from an elongated metal electrode. However, this is only for illustration purpose, and in other embodiments, the upper electrode **120** may also be of other shapes or layout designs.

Furthermore, the lower electrode **130** in this embodiment is, for example, a metal layer. This metal layer can enhance collection of carriers and also recycle photons that are not absorbed. Likewise, the lower electrode **130** may also be of other different shapes depending on designs of different users,

The passivation layer **140** covers at least one of the plurality of side surfaces **110c** so as to reduce the leakage current formed on the side surfaces **110c,** as shown in **FIG. 1****.** Particularly, the passivation layer **140** at least covers the side surfaces **110c** at an interface (p-n junction) between the first type semiconductor layer **112** and the second type semiconductor layer **114.** The reason for this is as follows. As both the first type semiconductor layer **112** and the second type semiconductor layer **114** are doped semiconductor layers, a lot of defects may be formed at the interface between the first type semiconductor layer **112** and the second type semiconductor layer **114.** Consequently, water vapor or atoms of other impurities may easily intrude into the photovoltaic layer **110** through the side surfaces **110c** near the p-n junction so as to cause failure or a shortened service life of the photovoltaic layer **110.** Disposition of the passivation layer **140** can not only protect the side surfaces **110c** near the p-n junction from intrusion of water vapor or dirt, but also prevent forming of the leakage current between the first type semiconductor layer **112** and the second type semiconductor layer **114.** Hence, through disposition of the passivation layer **140** on the side surfaces **110c** of the photovoltaic layer **110,** the solar cell structure **100** can be made to have a longer service life and a higher photoelectric conversion efficiency. Additionally, in some embodiments, the passivation layer **140** may also completely cover all surfaces of the solar cell **100** that are exposed to the outside.

In this embodiment, the passivation layer **140** may be made of a paint, an insulation material, a compound comprising one of the oxygen and nitrogen element, or a combination thereof. As an example, the compound may be made of silicon oxide, silicon nitride, silicon oxynitride, or a combination thereof. However, choice of the material of the passivation layer **140** may depend on requirements and designs of different users, and what described above is only provided for illustration purpose but is not to limit the present invention.

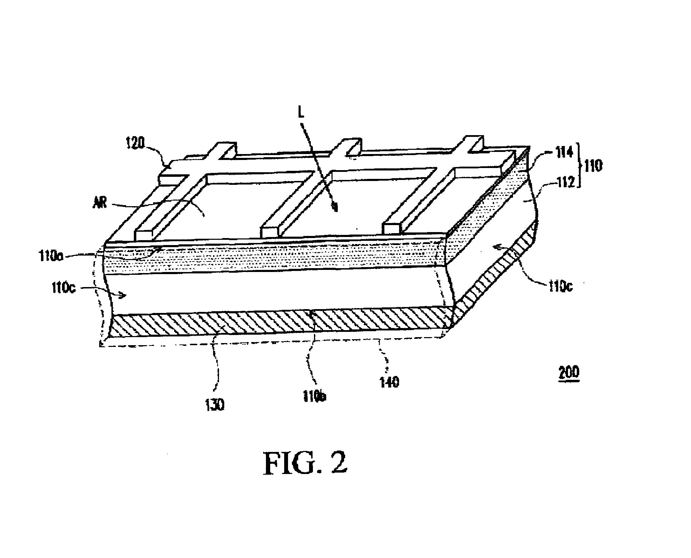

**FIG. 2** is a schematic partial view of a solar cell structure according to another embodiment of the present invention. Referring to **FIG. 2****,** the solar cell structure **200** comprises all the members of the aforesaid solar cell structure **100.** For these identical members, they will be denoted with identical reference numerals and will not be further described again herein.

It shall be appreciated that, the solar cell structure **200** further comprises an anti-reflection layer **AR** disposed between the second type semiconductor layer **114** and the upper electrode **120.** In detail, when the light ray **L** is incident on the upper surface **110a** of the photovoltaic layer **110,** the anti-refiection layer **AR** on the upper surface **110a** may help to increase the chance that the light ray **L** propagates into the photovoltaic layer **110** and decrease the chance that the light ray **L** is reflected off the upper surface **110a** of the photovoltaic layer **110** so that the light ray **L** can be well absorbed by the photovoltaic layer **110.** The anti-reflection layer **AR** is made of, for example, silicon oxynitride, silicon nitride or the like,

,A method for manufacturing the solar cell **100** will be described hereinafter.

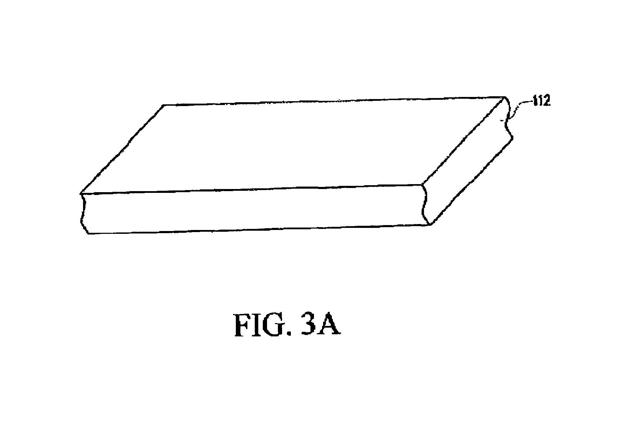

**FIGs. 3A** to **3E** schematically illustrate a process of manufacturing a solar cell structure according to an embodiment of the present invention. Firstly, referring to **FIG. 3A****,** a first type semiconductor layer **112** is provided. In this embodiment, the first type semiconductor layer **112** may be, for example, the P-type semiconductor layer described above that is formed by adding a group III element of periodic table such as boron (B), gallium (Ga), indium (In) or the like into a highly pure silicon crystal substrate,

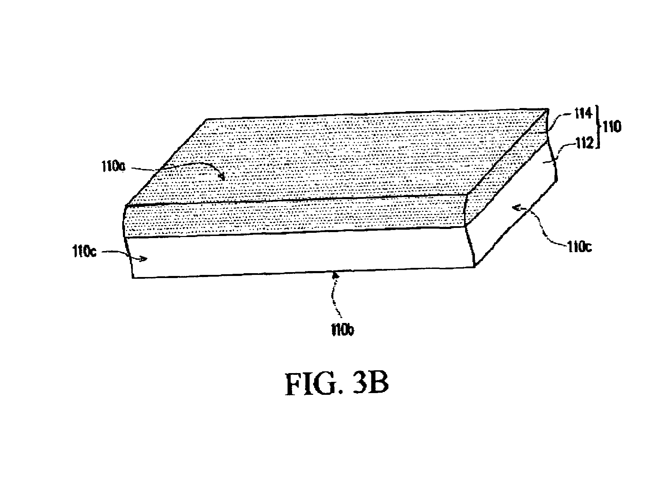

Then, referring to **FIG. 3B****,** a second type semiconductor layer **114** is formed on the first type semiconductor layer **112** to construct a photovoltaic, layer **110.** The photovoltaic layer **110** has an upper surface **110a,** a lower surface **110b** and a plurality of side surfaces **110c,** In this embodiment, the second type semiconductor layer **114** is, for example, an N-type semiconductor layer and is formed on the first type semiconductor layer **112** by, for example, performing a doping process on the first type semiconductor layer **112.** More specifically, the doping process may be performed by a furnace diffusion unit or an ion implantation unit.

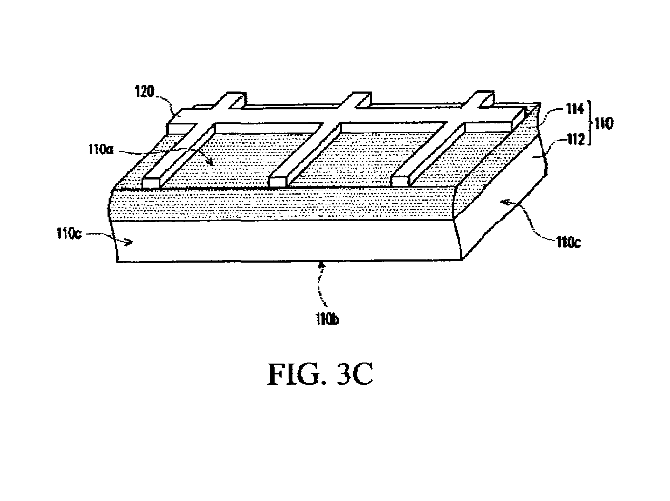

Next, referring to **FIG. 3C****,** an upper electrode **120** is formed on the upper surface **110a** of the photovoltaic layer **110** so as to electrically connect the upper electrode **120** with the second type semiconductor layer **114.** The second type semiconductor layer **114** is located between the upper electrode **120** and the first type semiconductor layer **112.** In this embodiment, the upper electrode **120** may be formed through a screen printing process and a thermal process. In this embodiment, for example, a silver paste is firstly screen printed on the upper surface **110a** of the photovoltaic layer **110,** and then the photovoltaic layer **110** is subjected to the thermal process to form the silver paste into silver wires fixed at specific locations on the upper surface **110a.** In other embodiments, the upper electrode **120** may also be formed through other appropriate processes, for example, through a metal-oxide vapor deposition process, an evaporation process or a sputtering process.

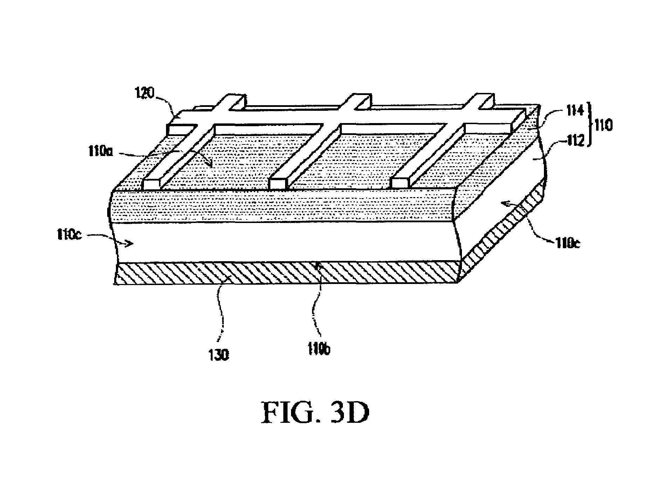

Referring further to **FIG. 3D**, a lower electrode **130** is formed on the lower surface **110b** of the photovoltaic layer **110** so as to electrically connect the lower electrode **130** with the first type semiconductor layer **112.** The first type semiconductor layer **112** is located between the lower electrode **130** and the second type semiconductor layer **114.** In this embodiment, the lower electrode **130** may be formed through a screen printing process and a thermal process. In this embodiment, for example, an aluminum paste is firstly screen printed on the lower surface **110b** of the photovoltaic layer **110,** and then the photovoltaic layer **110** is subjected to the thermal process to form the aluminum paste into an aluminum layer that completely covers the lower surface **110b** or into some other pattern located at specific locations on the lower surface **110b.**

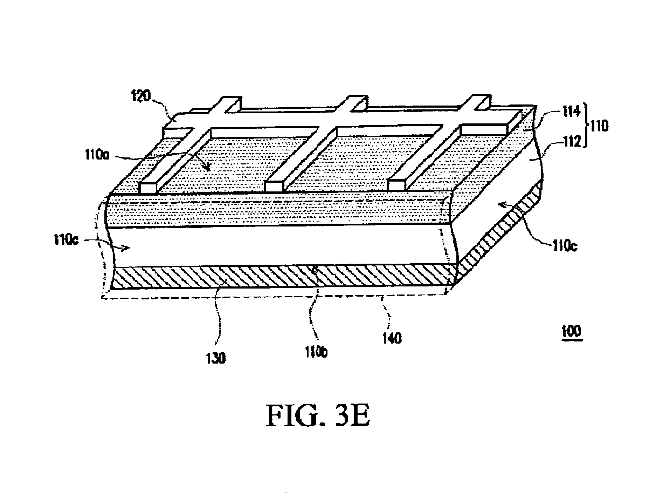

Subsequently, referring to **FIG. 3E****,** a passivation layer **140** covering at least one of the side surfaces **110c** is formed to reduce the leakage current formed on the side surfaces **110c.** In this embodiment, the passivation layer 140 is formed through, e.g., a plasma process, a coating process or a thermal process. For example, in case of the plasma process. CO₂ may be used as a reactant gas so that a CO₂ plasma reacts with silicon to form silicon oxide; in case of the coating process, a white paint may be coated on the surfaces to be protected; and in case of the thermal process, a furnace process with a high oxygen partial pressure may be used. Thus, the method for manufacturing the aforesaid solar cell structure **100** is substantially completed.

In some embodiments, subsequent to the step shown in **FIG. 3A****,** a texture surface may be formed on the upper surface **110a** or the lower surface **110b** of the photovoltaic layer **110.** The texture surface may be formed by, e.g., performing an etching process. For example, the photovoltaic layer **110** may be immersed into a **KOH** solution of an appropriate concentration to form a plurality of pyramidal micro-structures on the upper surface **110a** or the lower surface **110b** of the photovoltaic layer **110.** In other embodiments, the texture surface may also be formed through a dry etching process.

In another embodiment, an anti-reflection layer **AR** may also be formed between the second type semiconductor layer **114** and the upper electrode **120** to reduce reflection of the light ray **L,** as shown in **FIG. 2****.** For example, the anti-reflection layer **AR** may be formed of silicon oxide (SiO₂), silicon nitride (Si₃N₄), or a dual-layer structure of magnesium fluoride and zinc sulfide (MgF₂/ZnS) through a plasma enhanced chemical vapor deposition (PECVD) process. Furthermore, the anti-reflection layer **AR** may also serve the passivation function to reduce recombination loss of charge carriers of the surface of the solar cell structure 100 on the photovoltaic layer **110.**

According to the above descriptions, because the solar cell structure of the present invention has a passasivation layer disposed on the side surfaces of the photovoltaic layer, the leakage current formed on the side surfaces of the photovoltaic layer can be reduced and influence of water vapor or dirt from the outside can be avoided. In other words, the solar cell of the present invention can have preferred photoelectric conversion efficiency and a long service life. In addition, the method for manufacturing a solar cell of the present invention can form the aforesaid passivation layer in the solar cell structure through a simplified process, thereby improving the performance of the resulting solar cell structure.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A solar cell structure, comprising:
a photovoltaic layer, having an upper surface, a lower surface and a plurality of side surfaces, and comprising:
a first type semiconductor layer; and
a second type semiconductor layer, being physically connected with the first type semiconductor layer;
an upper electrode, being disposed on the upper surface of the photovoltaic layer and electrically connected with the second type semiconductor layer, the second type semiconductor layer being located between the upper electrode and the first type semiconductor layer;
a lower electrode, being disposed on the lower surface of the photovoltaic layer and electrically connected with the first type semiconductor layer, the first type semiconductor layer being located between the lower electrode and the second type semiconductor layer; and
a passivation layer, covering at least one of the side surfaces so as to reduce a leakage current formed on the side surfaces.

2. The solar cell structure as claimed in claim 1, wherein the photovoltaic layer is made of a monocrystalline material or a polycrystalline material.

3. The solar cell structure as claimed in claim 2, wherein the photovoltaic layer is made of a monocrystalline or polycrystalline material of at least one of silicon (Si), gallium arsenide (GaAs), and indium phosphide (InP),

4. The solar cell structure as claimed in claim 1, wherein the passivation layer is made of a paint, an insulation material, a compound comprising one of the oxygen and nitrogen element, or a combination thereof.

5. The solar cell structure as claimed in claim 1, wherein the first type semiconductor layer is a P-type semiconductor layer, and the second type semiconductor layer is an N-type semiconductor layer.

6. The solar cell structure as claimed in claim 1, further comprising an anti-reflection layer disposed between the second type semiconductor layer and the upper electrode.

7. The solar cell structure as claimed in claim 1, wherein at least one of the upper surface and the lower surface is a texture surface.

8. A method for manufacturing a solar cell structure, comprising:
providing a first type semiconductor layer;
forming a second type semiconductor layer on the first type semiconductor layer so as to form a photovoltaic layer, wherein the photovoltaic layer has an upper surface, a lower surface and a plurality of side surfaces;
forming an upper electrode on the upper surface of the photovoltaic layer so as to electrically connect the upper electrode with the second type semiconductor layer, wherein the second type semiconductor layer is located between the upper electrode and the first type semiconductor layer;
forming a lower electrode on the lower surface of the photovoltaic layer so as to electrically connect the lower electrode with the first type semiconductor layer, wherein the first type semiconductor layer is located between the lower electrode and the second type semiconductor layer; and
forming a passivation layer that covers at least one of the side surfaces so as to reduce a leakage current formed on the side surfaces.

9. The method for manufacturing a solar cell structure as claimed in claim 8, wherein the first type semiconductor layer is a P-type semiconductor layer, and the second type semiconductor layer is an N-type semiconductor layer.

10. The method for manufacturing a solar cell structure as claimed in claim 8, wherein forming the second type semiconductor layer on the first type semiconductor layer comprises performing a doping process on the first type semiconductor layer.

11. The method for manufacturing a solar cell structure as claimed in claim 8, further comprising forming a texture surface on at least one of the upper surface and the lower surface of the photovoltaic layer.

12. The method for manufacturing a solar cell structure as claimed in claim 11, wherein forming the texture surface on at least one of the upper surface and the lower surface of the photovoltaic layer comprises performing an etching process.

13. The method for manufacturing a solar cell structure as claimed in claim 8, further comprising forming an anti-reflection layer between the second type semiconductor layer and the upper electrode.

14. The method for manufacturing a solar cell structure as claimed in claim 8, wherein forming the passivation layer comprises performing a plasma process, a coating process or a thermal process.

15. The method for manufacturing a solar cell structure as claimed in claim 8, wherein forming the upper electrode or forming the lower electrode comprises performing a screen printing process and a thermal process.
